# EUROPEAN PATENT APPLICATION

(11) **EP 0 991 307 A2**
(43) Date of publication of application: **05.04.2000**
(21) Application number: 99307054.9
(22) Date of filing: 06.09.1999
(51) Int. Cl.: H05K 5/00

(54) **Method of assembling an electronics housing and a housing formed thereby**

(30) Priority: 11.09.1998 GB 9819918
(71) Applicant: Meggitt Mobrey Limited, Wimborne, Dorset BH21 4EL (GB)
(72) Inventor: Turner, Roy Colin, Maidenhead, Berks SL6 8DH (GB)
(74) Representative: Skone James, Robert Edmund

(57) **Abstract**

The invention describes an electronics housing assembly particularly suitable for a vibrating fork liquid level sensor [5]. The housing is formed by body parts [6,10] which define an internal cavity [9] to receive electronic components [11]. The components [11] and the body part [10] include co-operating connector parts [19, 27] which engage when the body parts [8, 10] are assembled together. This eliminates conventional soldering steps and ensures an electrical connection is made at the same time as physical interconnection occurs.

## Description

### Field of the Invention

This invention relates to a method of assembling an electronics housing, and to a housing formed thereby, and has been developed in particular, though not necessarily solely, for assembling and housing electronics incorporated in a vibrating fork level sensor.

### Background of the Invention

Vibrating fork level sensors typically include a cavity, sealed from the outside environment, in which the operating electronics for the sensor are mounted. Power may be fed to the electronics through external terminals moulded into, and passing through, a cap which partly defines the cavity. Typically the electronics are mounted on a printed circuit board and this is connected to the internal ends of the terminals through soldered connections. Such terminals require relatively skilled labour during assembly, take time to effect, and thus contribute significantly to the cost of the sensor.

It is an object of this invention to provide a method of assembling an electronics housing and/or a housing assembly which will go at least some way in addressing the aforementioned problems, or which will at least provide a useful choice.

### Summary of the Invention

Accordingly, in one aspect, the invention provides an electronics housing including:
a first body part;
a second body party engageable with said first body part to define a cavity closed from an external environment, said second body part having electrical terminals passing therethrough;
said housing being characterised in that at least one sliding connection is provided between said second body part and said electronics carrier.

Preferably said electronics carrier comprises a printed circuit board.

Preferably said first body part includes a cylindrical wall section and said second body part comprises a cap engageable with an end of said cylindrical wall section.

Preferably all connections between said printed circuit board and said cap are sliding connections and, to this end, the printed circuit board and the cap preferably include co-operating male and female connector parts. The cap preferably engages with the cylindrical wall section along an engagement axis, said male and female parts being preferably aligned parallel to said engagement axis.

The cap preferably includes first alignment means, engageable by said printed circuit board, to aid alignment of the connector parts on said cap and on said printed circuit board. Second alignment means are preferably provided to ensure correct alignment between said cap and said cylindrical wall section.

Preferably a piezoelectric element is also housed within said cavity, said piezoelectric element being connected to said printed circuit board. The connection between said piezoelectric element and said circuit board is preferably by way of a push-fit connector.

A re-enterable encapsulant is preferably provided over said piezoelectric element said encapsulant being of a composition, and being so positioned, as to bias the printed circuit board toward said cap.

Preferably sealing means is provided between said cap and said cylindrical wall section. The sealing means conveniently comprises an O-ring which may be supplemented by potting compound.

In a second aspect the invention comprises a method of providing an electronics housing, said method including the steps of:
providing a first body part;
providing a second body part engageable with said first body part to define a cavity closed from an external environment, said second body part having electrical terminals passing therethrough;
locating an electronics carrier within one of said body parts such that, when said body parts are engaged, said electronics carrier is enclosed within said cavity;
said method being characterised in that said electronics carrier is engaged with at least one of said electrical terminals by a sliding connection.

Preferably all connections between said electronics carrier and said second body part comprise sliding connections, all of said connections being preferably constructed and arranged to be effected substantially simultaneously.

Preferably said second body part comprises a cap engageable with a cylindrical wall section and said electronics carrier comprises a printed circuit board, said cap and said printed circuit board preferably including co-operable male and female connector parts, said board preferably being assembled into said cap prior to said cap being engaged with said cylindrical wall section.

Preferably said method further includes forming at least one earth connection between said board and said cylindrical wall section simultaneously with engaging said cap with said cylindrical wall section.

Preferably said method still further includes mounting a piezoelectric element within said cavity before engaging said first and second body parts, and connecting said piezoelectric element to said printed circuit board. Said piezoelectric element is preferably connected to said printed circuit board by a push-fit connector.

In a third aspect the invention comprises a vibrating fork level sensor including the electronics housing, or when formed by application of the method, as set forth above.

In a fourth aspect the invention provides a vibrating fork level sensor of the type which includes;
a body having an internal cavity closed to an external environment;
at least one electrical terminal passing through said body to provide an electrical conducting path between said cavity and said external environment;
an electronics carrier within said cavity, said electronics carrier being connected to said at least one electrical terminal;
a piezoelectric element mounted within said cavity and being connected to said electronics carrier,
said sensor being characterised in that sliding connections are provided between said at least one electrical terminal and said electronics carrier, and between said piezoelectric element and said electronics carrier.

### Brief Description of the Drawings

One preferred form of apparatus embodying the invention will now be described with reference to the accompanying drawings in which:
- Figure 1:: shows a cross sectional view through a vibrating fork level sensor embodying a housing according to the invention;
- Figure 2:: shows an enlarged sectional view through a cap incorporated in the sensor shown in Figure 1;
- Figure 3:: shows a view along the line III-III in Figure 1 with certain features omitted for the sake of clarity; and
- Figure 4:: shows a view along the line IV-IV in Figure 1 with certain features omitted for the sake of clarity.

### Detailed Description of Working Embodiment

Referring to the drawings, the present invention provides an electronics housing which, in the embodiment depicted and described, is incorporated in a vibrating fork liquid level sensor 5.

As can be seen, the sensor 5 includes a first body part 6 which includes a pair of spaced forks projecting from the lower edge thereof, one of the forks being shown at 7. The upper section of the first body part 6 is, in the form shown, defined by a cylindrical wall section 8 which may be formed integrally with the lower part or may be sealingly fixed to the lower part. The cylindrical wall section 8 partly defines a cavity 9, the cavity 9 being closed by a second body part, preferably in the form of cap 10, which sealingly engages with the upper end of wall section 8 and isolates the cavity 9 from the external environment.

Located within the cavity 9 are the electronics which control the operation of the sensor 5. In the conventional manner, the bulk of these electronics are mounted on a single carrier which preferably comprises a printed circuit board 11. In the embodiment shown, the board 11 is aligned parallel to the axis of the cylindrical wall section 8 and, at its upper end, preferably engages in alignment channels 12 formed in the inner surface of the cap 10. At its lower end, the board 11 is preferably located in a plug 13 of re-enterable encapsulant which will be described in greater detail below.

The alignment channels 12, if provided, serve to align the printed circuit board 11 with respect to the cap 10. The cap 10 preferably includes an alignment lug 14 on a downward facing surface thereof, which lug 14 engages in notch 15 formed in the upper edge of the cylindrical wall section 8. By engaging lug 14 in notch 15 the cap 10 can be aligned with respect to the first body part 6.

Sensors of the type herein described typically include a piezoelectric element 16 which, when subjected to an appropriate electric driving current, deforms and causes the forks 7 to vibrate. The element 16 must be connected to the drive electronics mounted on the board 11 and, in the embodiment depicted, this is achieved through a simple push fit connector 17, one half of the connector 17 being mounted on leads 18 extending from the piezoelectric element 16 and the other part of the connector being mounted on the printed circuit board 11.

The piezoelectric element 16 is bonded into the inner surface of that section of the body part 6 from which forks 7 project. The element 16 is then covered by the plug 13 of encapsulant which, as can be seen, fills the lower part of cavity 9. The encapsulant is a setable yet flexible potting compound which may comprise or include silicones or polyurethane, and serves to seal off the element 16 from the remainder of components in the cavity 9, fix the positions of leads 18, and also to locate the lower end of the board 11 and to elastically bias the printed circuit board 11 into engagement with the cap 10.

The cap 10 not only serves to seal off the inner cavity 9 from the environment surrounding the sensor 5, but also mounts electrical terminals 19 through which electrical energy is fed from an external source to the printed circuit board 11. The cap 10 is conveniently a plastics injection moulding and, in the course of manufacture, the terminals 19 are preferably located in the moulding die and plastics then injected into the die so as to form the cap, and fix the terminals 19 in position, simultaneously. It will be appreciated, however, that the cap 10 could be provided as a number of parts which combine to retain the terminals 19 therebetween.

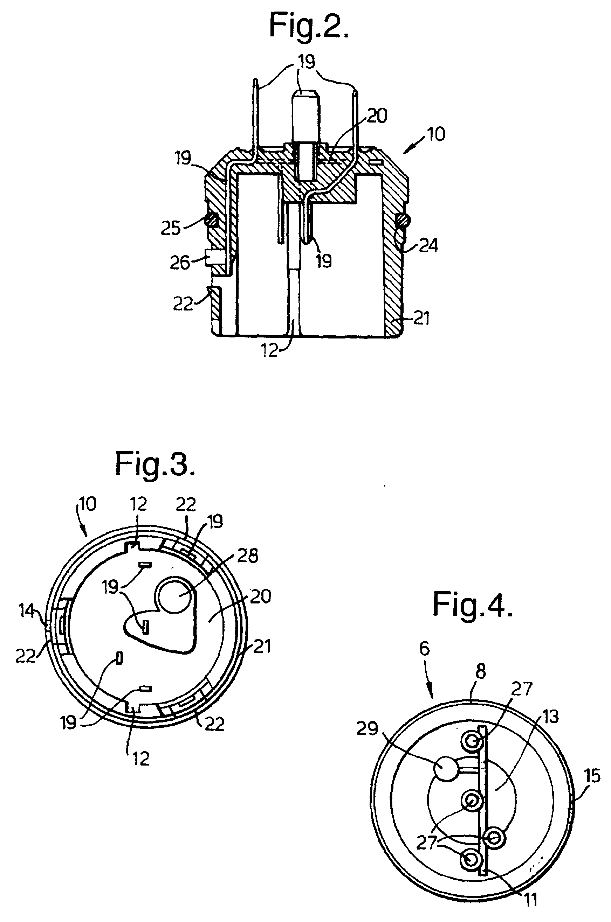

As can been seen in greater detail in Figures 2 and 3, the cap 10 comprises a closed end part 20 through which the terminals 19 pass, and a skirt 21 which extends down from the periphery of end part 20. The skirt 21 is sized to form a sliding fit within the upper end of sleeve 8 and preferably includes fixing tabs 22 which elastically deform as the skirt is engaged in the cylindrical wall section 8 and then recover when the tabs enter fixing groove 23 provided on the inner surface of wall section 8. The skirt 21 is also provided with an external peripheral groove 24 which locates an 0-ring seal 25 to seal between the cap 10 and the sleeve 8. The seal 25 may be supplemented by a sealant such as potting compound (not shown) applied about the joint between the cap 10 and the body part 6.

The terminals 19 pass through the cap end part 20 to, in the main, project below the inner surface of the cap end part 20. However one of the terminals has arms extending partly down inside the skirt 21 and includes at least one and, in the form shown three, tabs 26 which emerge laterally from the outer surface of the skirt to engage the inner surface of wall section 8 as the cap 10 is engaged with the wall section 8, and thereby form earth connections between the board 11 and the body part 6.

Those terminals 19 which project downwardly from the inner surface of cap part 20 lie, as can be seen, parallel to the axis of the skirt 21, which axis conveniently defines an engagement axis along which the cap 10 engages with the wall section 8.

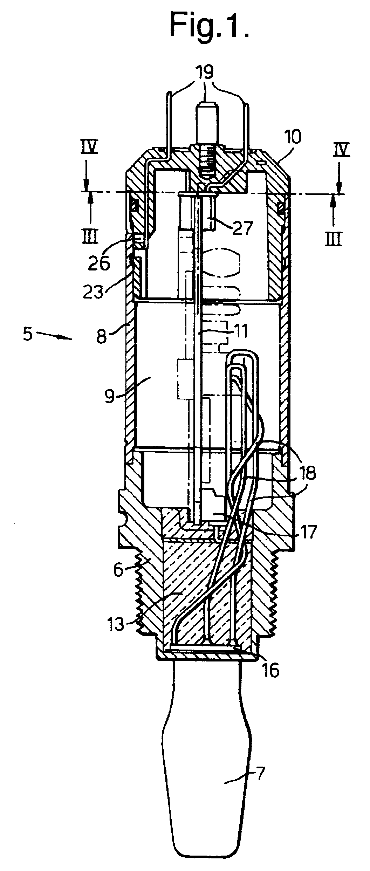

Located on the upper edge of the printed circuit board 11 are a series of female sockets 27 aligned parallel to the plane of the board 11, one socket being provided for each of the terminals 19 projecting from the inner surface of the cap 10. The sockets are appropriately located on the board 11, and the terminals appropriately located within the cap 10, so that when the printed circuit board 11 is correctly located in slots 12, the simple act of pushing the board 11 further into the cap 10, causes each of the sockets 27 to slidingly engage over its respective terminal 19. It will be appreciated that when the cap 10 is then fully engaged within the cylindrical wall section 8, the lower end of board 11 engages with the plug 13 of flexible encapsulant which biases the board 11 towards the cap 10 and thus maintains terminals 19 in full engagement within sockets 27 as shown in Figure 1.

In the form shown, the cap 10 is a substantially transparent moulding and further includes a pocket 28 on the inner surface of end part 20, the pocket 28 being sized to receive an LED 29 projecting from the printed circuit board 11. The LED 29 can be viewed from the outside environment and, in use, may serve to indicate various operating states of the sensor 5 although this feature does not form part of the present invention.

The configuration of electronics housing included in the sensor 5 described, provides significant benefits during assembly.

It will be appreciated that the piezoelectric element 16 with attached leads 18 and part of connector 17 is formed as a subassembly, as is the printed circuit board 11 with attached sockets 27.

As a first step in the final assembly process the piezoelectric element 14 is bonded into position on the inner surface of lower body part 6 leaving the leads 18 with attached part of connector 17 projecting out of cavity 9. The preferred next step is to align the edges of printed circuit board 11 with slots 12 in the cap 10 and to then push the board into cap 10 so engaging sockets 27 over terminals 19. The connector 17 is then completed by engaging that part of the connector mounted on leads 18, with that part of the connector mounted on the printed circuit board 11, by a simple push-fit process. This completes the required connections between the piezoelectric element and the printed circuit board.

The lug 14 on cap 10 is then aligned with notch 15 on the upper edge of the cylindrical wall section 8 and the cap then brought into engagement with cylindrical wall section. As this occurs the board enters cavity 9 until the lower edge engages in the plug 13 of encapsulant. Simultaneously the earth tabs 26 engage the inner surface of wall section 8 to establish an earth connection between the board 11 and the body part 6. When the cap 10 is fully in place within the wall section 8, tabs 22 engage in groove 23 to lock the cap in position.

It will thus be appreciated that the present invention provides a simple yet effective electronics enclosure, and/or method of forming an enclosure which allows final assembly of an electronic device such as a vibrating fork level switching sensor to be effected simply, quickly and reliably and without the need for relatively skilled operations such as soldering. As a consequence it is believed that a more reliable sensor can be produced with less expense.

## Claims

1. An electronics housing including:
a first body part;
a second body party engageable with said first body part to define a cavity closed from an external environment, said second body part having electrical terminals passing therethrough;
said housing being characterised in that at least one sliding connection is provided between said second body part and said electronics carrier.

2. An electronics housing as claimed in claim 1 wherein said first body part includes a cylindrical wall section and said second body part comprises a cap engageable with an end of said cylindrical wall section.

3. An electronics housing as claimed in claim 1 or claim 2 wherein all connections between said electronics carrier and said second body part are sliding connections.

4. An electronics housing as claimed in any one of the preceding claims wherein said electronics carrier comprises a printed circuit board and said second body part comprises a cap, and wherein said printed circuit board and said cap include co-operating male and female connector parts.

5. An electronics housing as claimed in claim 4 wherein said first body part includes a cylindrical wall section constructed and arranged to engage with said cap along an engagement axis, said male and female connector parts being aligned parallel to said engagement axis.

6. An electronics housing as claimed in claim 4 or claim 5 wherein said cap includes first alignment means, engageable by said printed circuit board, to aid alignment of the connector parts on said cap and on said printed circuit board.

7. An electronics housing as claimed in any one of claims 4 to 6 further including second alignment means to ensure correct alignment between said cap and said cylindrical wall section.

8. An electronics housing as claimed in any one of claims 4 to 7 further including a piezoelectric element housed within said cavity, said piezoelectric element being connected to said printed circuit board.

9. An electronics housing as claimed in claim 8 wherein the connection between said piezoelectric element and said circuit board includes a push-fit connector.

10. An electronics housing as claimed in claim 8 or claim 9 further including a re-enterable encapsulant provided over said piezoelectric element, said encapsulant being of a composition, and being so positioned, as to bias the printed circuit board toward said cap.

11. An electronics housing as claimed in any one of claims 4 to 10 further including sealing means between said cap and said cylindrical wall section.

12. An electronics housing as claimed in claim 11 wherein said sealing means comprises an O-ring.

13. A method of providing an electronics housing, said method including the steps of :
providing a first body part;
providing a second body part engageable with said first body part to define a cavity closed from an external environment, said second body part having electrical terminals passing therethrough;
locating an electronics carrier within one of said body parts such that, when said body parts are engaged, said electronics carrier is enclosed within said cavity;
said method being characterised in that said electronics carrier is engaged with at least one of said electrical terminals by a sliding connection.

14. A method as claimed in claim 13 wherein all connections between said electronics carrier and said second body part are sliding connections, said method including effecting all of said connections substantially simultaneously.

15. A method as claimed in claim 13 or claim 14 wherein said first body part includes a cylindrical body section, said second body part comprises a cap engageable with said cylindrical wall section and said electronics carrier comprises a printed circuit board, said method including assembling said printed circuit board into said cap prior to engaging said cap with said cylindrical wall section.

16. A method as claimed in claim 15 further including forming at least one earth connection between said printed circuit board and said cylindrical wall section simultaneously with engaging said cap with said cylindrical wall section.

17. A method as claimed in claim 15 or claim 16 further including mounting a piezoelectric element within said cavity and connecting said piezoelectric element to said printed circuit board.

18. A method as claimed in claim 17 wherein said piezoelectric element is connected to said printed circuit board by combining co-operating parts of a push-fit connector.

19. A vibrating fork level sensor including the electronics housing as claimed in any one of claims 1 to 12; or when formed by application of the method as claimed in any one of claims 13 to 18.

20. A vibrating fork level sensor of the type which includes;
a body having an internal cavity closed to an external environment;
at least one electrical terminal passing through said body to provide an electrical conducting path between said cavity and said external environment;
an electronics carrier within said cavity, said electronics carrier being connected to said at least one electrical terminal;
a piezoelectric element mounted within said cavity and being connected to said electronics carrier,
said sensor being characterised in that sliding connections are provided between said at least one electrical terminal and said electronics carrier, and between said piezoelectric element and said electronics carrier.
